# EUROPEAN PATENT APPLICATION

(11) **EP 3 755 129 A1**
(43) Date of publication of application: **23.12.2020**
(21) Application number: 20174593.2
(22) Date of filing: 14.05.2020
(51) Int. Cl.: H05K 1/02, H05K 1/11, H05K 3/28, H05K 3/38, H05K 3/40, H05K 3/46

(54) **CIRCUIT BODY, CONNECTION STRUCTURE OF A BOARD AND A CIRCUIT BODY, AND BUSBAR MODULE**

(30) Priority: 17.06.2019 JP 2019112233
(71) Applicant: YAZAKI CORPORATION, Minato-ku, Tokyo 108-8333 (JP)
(72) Inventor: YASUDA, Tomoji, Makinohara-shi, Shizuoka (JP); ICHIKAWA, Yoshiaki, Makinohara-shi, Shizuoka (JP); OGA, Tatsuya, Makinohara-shi, Shizuoka (JP)
(74) Representative: Grünecker Patent- und Rechtsanwälte PartG mbB

(57) **Abstract**

A circuit body includes a flexible circuit board including: a conductor wiring pattern for electrical connection; and a pair of protective layers sandwiching the wiring pattern to isolate the wiring pattern from outside. The wiring pattern has a conduction portion exposed to the outside through an opening located on at least one of the pair of the protective layers and to be electrically connected to an external terminal. The conduction portion has at least two overlap portions located around the opening and sandwiched between the pair of the protective layers in a thickness direction of the flexible circuit board.

## Description

### CROSS-REFERENCES TO RELATED APPLICATION(S)

This application is based on and claims priority from Japanese Patent Application No. 2019-112233 filed on June 17, 2019, and the entire contents of which are incorporated herein by reference.

### BACKGROUND

### Field of the Invention

The present invention relates to a circuit body, a connection structure of a board and a circuit body, and a busbar module.

### Description of Related Art

Conventionally, flexible circuit boards (FPCs; FPC stands for flexible printed circuits) are provided with wiring patterns are used as interconnections for connecting various kinds of electronic devices (refer to Patent document 1, for example). In general, flexible circuit boards have a structure that a thin-film conductor layer having prescribed wiring patterns (i.e., circuits) is sandwiched between insulating films and have, in particular, a feature that they can be deformed (e.g., curved) flexibly while their electric characteristics are maintained.

As for details of the above connector, refer to JP 2002-093995 A.

### SUMMARY

Incidentally, one method for attaching terminals for connection to an external device or the like to an end portion of a flexible circuit board is to form openings by removing portions of a protective layer of the flexible circuit board and connecting the terminals to portions of conductor layers (wiring patterns) exposed in the openings, respectively, by soldering or the like. However, in this case, if a strong force acts on a terminal unintentionally, a strong force is also exerted on the wiring pattern (conductive layer) via the terminal, possibly causing trouble that, for example, the wiring pattern is peeled off the protective layer.

An object of the invention is therefore to provide a circuit body capable of suppressing peeling between a conductor layer of a wiring pattern and a protective layer, a connection structure of such a circuit body and a board, and a busbar module using such a circuit body.

Embodiments of the present invention provide the following items [1] to [3]:
[1] A circuit body comprising a flexible circuit board including: a conductor wiring pattern for electrical connection; and a pair of protective layers sandwiching the wiring pattern to isolate the wiring pattern from outside,
   the wiring pattern having a conduction portion exposed to the outside through an opening located on at least one of the pair of the protective layers and to be electrically connected to an external terminal,
   the conduction portion having at least two overlap portions located around the opening and sandwiched between the pair of the protective layers in a thickness direction of the flexible circuit board.
[2] A connection structure of a board and a circuit body, the connection structure comprising: a board; the circuit body according to the item [1]; and a terminal electrically connecting the board and the circuit body,
   the terminal passing through the opening of the circuit body and being soldered to the conduction portion exposed in the opening to be connected to the wiring pattern and being electrically connected to a circuit wiring on the board.
[3] A busbar module to be attached to a battery assembly having a stack of a plurality of cells, the busbar module comprising:
   a circuit body having a flexible circuit board: including a conductor wiring pattern for electrical connection; and a pair of protective layers sandwiching the wiring pattern to isolate the wiring pattern from outside;
   a connector connected to an end portion of the circuit body;
   a plurality of busbars to be connected to corresponding electrodes of the plurality of the cells; and
   a holder holdings the busbars and being extendable in a stacking direction of the plurality of the cells,
   the wiring pattern having, at the end portion connected to the connector, a conduction portion exposed to the outside through an opening located on at least one of the pair of the protective layers and to be electrically connected to an external terminal,
   the conduction portion having at least two overlap portions located around the opening and sandwiched between the pair of the protective layers in a thickness direction of the flexible circuit board.

According to first aspect of the invention, relating to the item [1], the conduction portion of each wiring pattern is exposed through the corresponding opening of the protective later and has, around the opening, at least two overlap portions which are located at such positions as to be sandwiched between the pair of protective layers in the thickness direction of the flexible circuit board. With this structure, even if external force acts on a wiring pattern (in particular, conduction portion) via, for example, the terminal connected to the conduction portion, the overlap portions sandwiched between the pair of protective layers can receive the external force sustainably. As a result, peeling of each wiring pattern from the protective layer can be suppressed more successfully than in a case that there is only one overlap portion (e.g., a conduction portion is a portion including the end of each wiring pattern that is only one wiring pattern extending from the conduction portion).

According to second aspect of the invention, relating to the item [2], each wiring pattern whose peeling from the protective layer is suppressed as described above is connected to the board using the associated terminal. As a result, in this connection structure, proper electrical connection between the board and the circuit body can be maintained even if unintended external force acts on the connection structure.

According to third aspect of the invention, relating to the item [3], the conduction portion of each wiring pattern is exposed through the corresponding opening of the protective later and has, around the opening, at least two overlap portions which are located at such positions as to be sandwiched between the pair of protective layers in the thickness direction of the flexible circuit board. With this structure, even if external force acts on a wiring pattern (in particular, conduction portion) via, for example, the terminal connected to the conduction portion, the overlap portions sandwiched between the pair of protective layers can receive the external force sustainably. As a result, peeling of each wiring pattern from the protective layer in the connection portion of the circuit body and the connector can be suppressed more successfully than in a case that there is only one overlap portion (e.g., a conduction portion is a portion including the end of each wiring pattern that is only one wiring pattern extending from the conduction portion). Thus, peeling or the like at the contact between each terminal and the corresponding wiring pattern due to, for example, curving of the circuit body can be suppressed.

The invention can provide a circuit body capable of suppressing peeling between a conductor layer of a wiring pattern and a protective layer, a connection structure of such a circuit body and a board, and a busbar module using such a circuit body.

The invention has been described above concisely. The details of the invention will become more apparent when the modes for carrying out the invention (hereinafter referred to as an embodiment) described below are read through with reference to the accompanying drawings.

### BRIEF DESCRIPTION OF THE DRAWINGS

Fig. 1 is a perspective view of the whole of a busbar module according to an embodiment of the present invention.
Fig. 2 is a perspective view of a battery assembly to which the busbar module according to the embodiment is to be attached.
Fig. 3 is an enlarged perspective view of an end portion of a circuit body.
Fig. 4 is a perspective view showing how a main strip, a first branch portion, and a second branch portion of the circuit body are formed.
Fig. 5A is a perspective view showing a state that the second branch portion is bent so as to assume an S shape as a whole, Fig. 5B is a perspective view showing how the second branch portion is deformed when a busbar is moved rearward relatively, and Fig. 5C is a perspective view showing a state that the second branch portion is stretched when the busbar is moved forward relatively.
Fig. 6 is a perspective view of part of a holder.
Fig. 7 is a perspective view of a housing space of a busbar housing portion.
Figs. 8A-8C are perspective views showing modifications of a bent portion of each second branch portion of the circuit body; Fig. 8A shows a case that the bent portion assumes a Z shape as a whole, Fig. 8B shows a case that the bent portion assumes a C shape as a whole, and Fig. 8C shows a case that the bent portion assumes an O shape as a whole.
Fig. 9A is a perspective view showing a modification of the first branch portion and Fig. 9B is a perspective view showing a modification of the portion where each branch strip branches off the main strip.
Fig. 10A is a sectional view, taken so as to include part of a top metal layer, of part of the circuit body and Fig. 10B is a sectional view, taken so as to include part of a bottom metal layer, of the same part of the circuit body.
Fig. 11A is a sectional view, taken so as to include part of the top metal layer, of a front end portion of the circuit body and its neighborhood and Fig. 11B is a sectional view, taken so as to include part of the bottom metal layer, of the front end portion of the circuit body and its neighborhood
Fig. 12A is a sectional view how wiring patterns are connected to a terminal in the front end portion of the circuit body and Fig. 12B is a rough top view corresponding to Fig. 12A.

### DETAILED DESCRIPTION

### Embodiment

A busbar module 10 according to an embodiment of the present invention will be hereinafter described with reference to the drawings. The busbar module 10 according to the embodiment is used being attached to a battery assembly (i.e., a battery module in which plural cells are laid on each other) that is a drive power source installed in an electric vehicle, a hybrid vehicle, or the like.

### (Configuration of battery assembly 1)

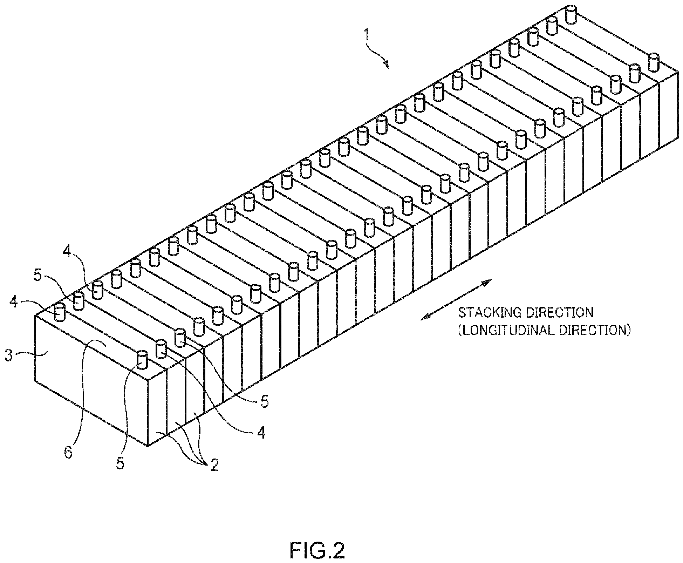

First, a battery assembly 1 to which the busbar module 10 according to the embodiment is to be attached will be described. As shown in Fig. 2, the battery assembly 1 is configured in such a manner that plural cells 2 are connected to each other in series. A positive electrode 4 and a negative electrode 5 project from the top of a cuboid-shaped battery main body (main body) 3 of each of the plural cells 2. The positive electrode 4 and the negative electrode 5, which are shaped like a cylinder, are spaced from each other and project upward approximately in the vertical direction from an electrode surface 6 of the battery main body 3.

The battery assembly 1 is configured by laying the cells 2 on each other in a prescribed direction (stacking direction) in such a manner that the positive electrodes 4 and the negative electrodes 5 of the cells 2 are arranged alternately. The positive electrode 4 of one of end cells 2 located at the two respective ends of the series connection of the cells 2 of the battery assembly 1 serves as an assembly positive electrode and the negative electrode 5 of the other end cell 2 serves as an assembly negative electrode.

### (Overall structure of busbar module 10)

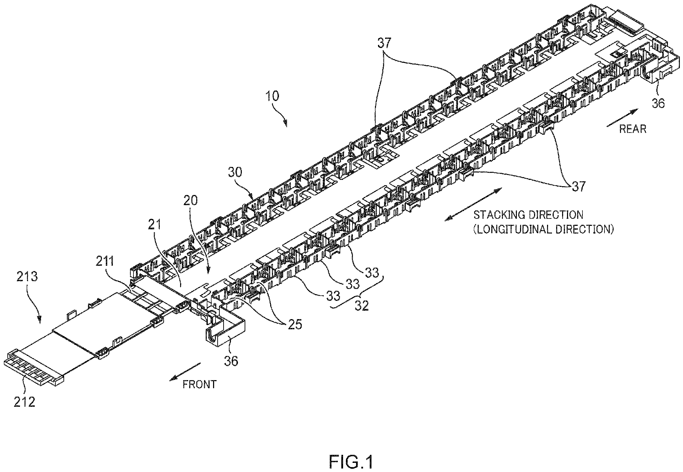

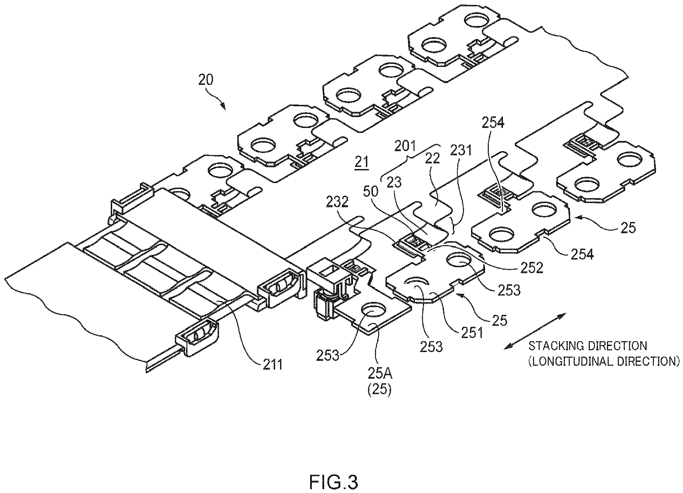

Next, the busbar module 10 according to the embodiment will be described. As shown in Fig. 1, the busbar module 10 has a circuit body 20 which is a flexible circuit board (FPC) and to which busbars 25 (see Fig. 3) to be connected to the positive electrodes 4 and the negative electrodes 5 of the cells 2 are attached and a holder (electrode routing body) 30 which houses and holds the circuit body 20 and attaches it to the battery assembly 1.

As shown in Figs. 1 and 3, the circuit body 20 has a band-shaped main strip 21 which is formed with plural wiring patterns (described later in detail) and is to extend over the cells 2 in their stacking direction. A connector 212 is attached to an end portion of the main strip 21 via voltage detection lines 211 which lead out of the main strip 21. The connector 212 can be connected to a voltage detection device (external device, not shown) that is provided outside the busbar module 10.

Band-shaped first branch portions 22 extending in the direction that crosses the longitudinal direction and the thickness direction of the main strip 21 (i.e., outward in the width direction of the main strip 21) are connected to the side edges, extending parallel with the longitudinal direction (in this example, substantially coincident with the stacking direction of the battery assembly 1) of the main strip 21. Band-shaped second branch portions 23 extend from the tips of the first branch portions 22, respectively, in parallel with the stacking direction of the battery main bodies 3. The main strip 21, the first branch portions 22, and the second branch portions 23 are an FPC and hence can be deformed flexibly particularly in the direction that is perpendicular to their planes.

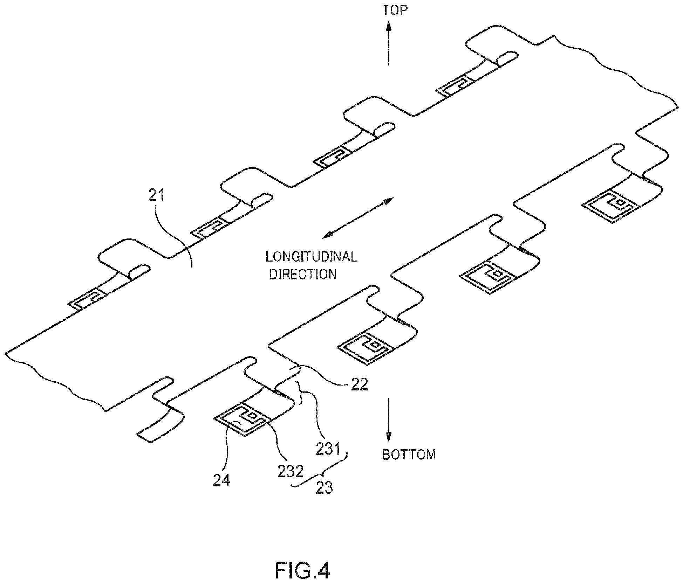

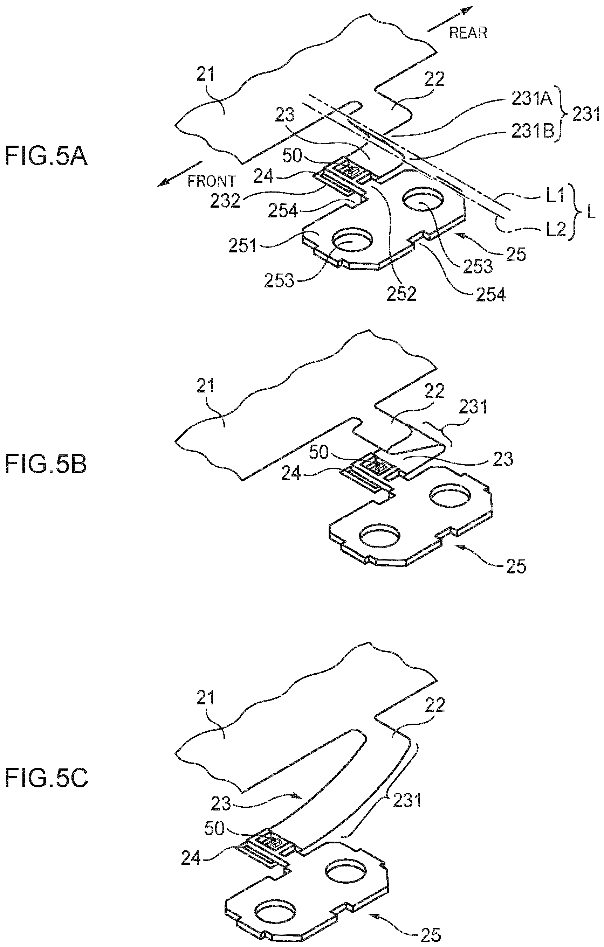

As shown in Figs. 4 and 5A, each second branch portion 23 has a bent portion 231 which is bent along lines L1 and L2 that cross the stacking direction (in this example, substantially coincident with the extension direction of the second branch portion 23) of the battery assembly 1 (that is, along axes extending parallel with the width direction of the second branch portion 23). Having a first bent portion 231A which is bent along the axis L1 and a second bent portion 231B which is bent along the axis L2, the second branch portion 23 is bent so as to assume an S shape (or an inverted S shape) as a whole. As such, the second branch portion 23 can move in the longitudinal direction of the main strip 21 (i.e., the stacking direction of the battery assembly 1) and extend and contract in the top-bottom direction.

The first branch portions 22 are located outside the main strip 21 in the same plane as the main strip 21, and the second branch portions 23 are connected to the respective first branch portions 22. Thus, the second branch portions 23 are located outside the main strip 21 in its width direction and extend generally downward so as to assume an S shape in a state that there is no deviation between the battery assembly 1 and the circuit body 20 (see Fig. 5A). Thus, the busbars 25 are located outside the main strip 21 in its width direction below the plane of the main strip 21.

An end portion, opposite to the first branch portion 22, of each second branch portion 23 is a tip portion 232 having a plane that is approximately parallel with the main strip 21, and a connection portion 24 is attached to the top surface of the tip portion 232. The bottom surface of the connection portion 24 is parallel with and at a different height as the bottom surface of the main strip 21, and hence these bottom surfaces are spaced from each other. The top surface of the connection portion 24 is connected to a busbar 25 that connects a positive electrode 4 and a negative electrode 5 of adjacent cells 2 of the battery assembly 1. Since the second branch portion 23 is thus connected to the electrodes 4 and 5 of those cells 2 via the connection portion 24 and the busbar 25, the associated voltage detection line 211 is connected to the electrodes 4 and 5.

As shown in Figs. 3 and 5A, each busbar 25 is a plate-like conductive member (made of copper, for example) and has a busbar main body 251 which is rectangular as a whole and a connection piece 252 which projects from the busbar main body 251 to the side of the main strip 21. Two electrode holes 253 into which a positive electrode 4 and a negative electrode 5 of adjacent cells 2 are to be inserted, respectively, penetrate through the busbar main body 251. The side edge located on the side of the main strip 21 and the opposite side edge of the busbar main body 251 are formed with respective positioning recesses 254 at positions corresponding to the middle between the two electrode holes 253. The connection portion 24 of the second branch portion 23 is connected to the bottom surface of the connection piece 252 of the busbar 25.

Busbars 25A that are located at the two respective ends of the main strip 21 in its longitudinal direction are connected to the assembly positive electrode or the assembly negative electrode and are each formed with one electrode hole 253 through which the assembly positive electrode or the assembly negative electrode is to be inserted. Power cables (not shown) for extracting power from the battery assembly 1 are connected to the respective busbars 25A. The internal structures of the main strip 21, the first branch portion 22, and the second branch portion 23 which constitute the circuit body 20 will be described later.

### (Structure of holder 30)

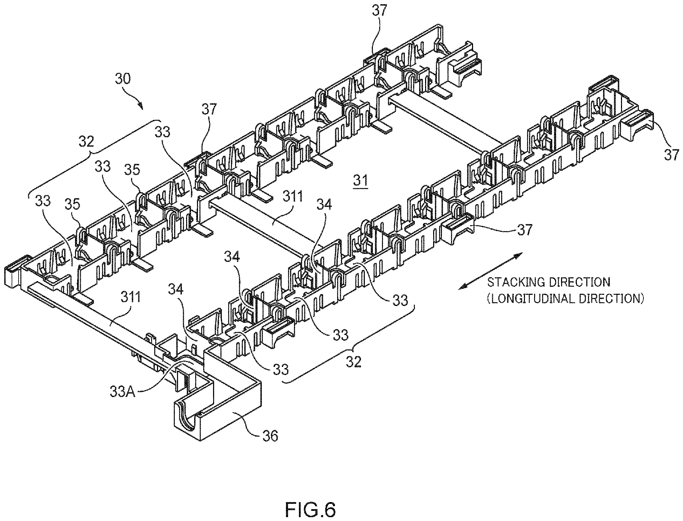

As shown in Fig. 6, the holder 30 is made of a resin, for example, and has, at the center in the width direction, a main strip housing portion 31 which extends in the stacking direction of the cells 2 and houses and holds the main strip 21 of the circuit body 20. The main strip housing portion 31 is provided with main strip support members 311 which are arranged at prescribed intervals in the longitudinal direction of the main strip 21 to be housed. The main strip 21 is put on the main strip support members 311. The main strip support members 311 may be omitted if the main strip 21, the first branch portions 22, and the second branch portions 23 are strong enough to allow the circuit body 20 of this example to be self-supported even if it is not supported by the main strip support members 311. The main strip support members 311 may be provided even in such a case to exercise an auxiliary support function even in a case that the circuit body 20 cannot be self-supported for a certain reason. That is, the circuit body 20 may be either put on and supported by the main strip support members 311 or self-supported without the main strip support members 311.

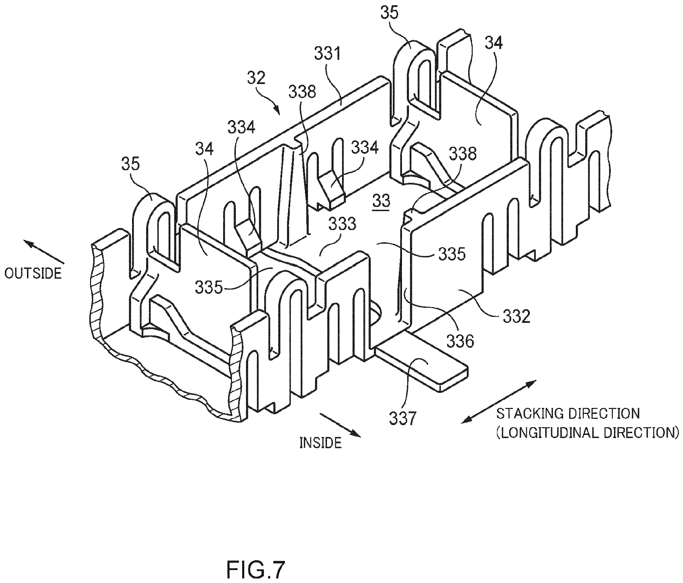

Two busbar housing portions 32 for housing the busbars 25 are provided outside the main strip housing portion 31 in the width direction. Each busbar housing portion 32 is provided with plural housing spaces 33 which are to house respective busbars 25 and are arranged in the stacking direction of the cells 2. As also shown in Fig. 7, adjacent housing spaces 33 are bounded by a partition wall 34, whereby the busbars 25 housed there are prevented from coming into contact with each other. Housing spaces 33A for housing the busbars 25A to which the power cables (not shown) are connected, respectively, are provided adjacent to the two respective ends of the main strip 21 in its longitudinal direction, and power cable housing portions 36 are provided so as to be continuous with the respective housing spaces 33A.

As shown in Fig. 7, each housing space 33, which is a rectangular space that is open at the top, is bounded by an outer wall 331 located outside in the width direction, an inner wall 332 located inside in the width direction, and a pair of partition walls 34 located on the two respective ends in the stacking direction. The partition wall 34 located on one side in the stacking direction (the left-side partition wall 34 in Fig. 7) is connected to the outer wall 331 and the inner wall 332 via respective extendable/contractable portions 35. Thus, each housing space 33 can extend and contract in the stacking direction.

Bottom end portions of the outer wall 331 and the inner wall 332 are connected to each other by a connection plate 333. The bottom end portions of the outer wall 331 and the inner wall 332 are formed with lock nails 334 inside, whereby a busbar 25 can be held between the connection plate 333 and the lock nails 334. Projections 338 project inward from the inner side surfaces of the outer wall 331 and the inner wall 332 at the centers in the stacking direction, respectively. The projections 338 serve to position the associated busbar 25 by fitting into the respective positioning recesses 254 (see Fig. 5A) of the busbar 25.

The inner wall 332 is formed with a cut 336 and a support plate 337 projects inward at a position corresponding to the cut 336. As a result, the connection piece 252 of the busbar 25 housed in the housing space 33 is supported by the support plate 337.

The connection plate 333 is formed with spaces 335 on the two respective sides of the center in the stacking direction. Thus, the positive electrode 4 and the negative electrode 5 of the cells 2 can be exposed in the housing space 33 through the respective spaces 335 and can be connected to the electrode holes 253 of the busbar 25 housed in the housing space 33. A bottom plate may be provided in place of the connection plate 333 so as to be formed with cuts or holes corresponding to the positive electrode 4 and the negative electrode 5 of the cells 2, respectively.

As shown in Fig. 1, the holder 30 houses and holds a portion of the circuit body 20, the portion being located in the rear of a position that is located in the rear of the front end, to which the connector 212 is connected, of the main strip 21 by a prescribed length (i.e., the portion in a range including at least positions where the first branch portions 22 branch off the main strip 21). In other words, a portion (hereinafter referred to as an "exposed portion 213"), having the prescribed length from the front end, to which the connector 212 is connected, of the main strip 21 is not housed in the holder 30 and is exposed from the holder 30.

### (Operation of busbar module 10)

Next, a description will be made of how the busbar module 10 operates. Fig. 5A shows a state that the second branch portion 23 is bent so as to assume an S shape as a whole, Fig. 5B shows a state that the second branch portion 23 is stretched rearward a little, and Fig. 5C shows a state that the second branch portion 23 is stretched forward.

As described above, the main strip 21 is put on the main strip support members 311 of the holder 30 and hence can move upward and in the longitudinal direction. Although the busbars 25 are housed in the respective housing spaces 33, the housing spaces 33 can move in the longitudinal direction of the main strip 21. The main strip 21 is connected to the busbars 25 via the respective second branch portion 23 which are bent in an S shape (see Fig. 5A).

Even if, for example, the battery assembly 1 is deformed in this state and the relative positional relationship between the battery assembly 1 and the circuit body 20 is changed and the relative positional relationships between the main strip 21 and the busbars 25 are thereby changed, the changes (deviations) in the relative positional relationships can be absorbed by bending or stretching of the second branch portions 23. Likewise, even if the size of the battery assembly 1 in its stacking direction varies from one battery assembly 1 manufactured to another due to an assembling allowance of the plural cells 2, that manufacture dispersion can be absorbed by bending or stretching of the second branch portions 23.

This will be described below more specifically. Fig. 5B shows a case that the busbar 25 has deviated a little rearward (rightward in Fig. 5B) with respect to the main strip 21. In this case, the S shape of the bent portion 231 of the second branch portion 23 is deformed to absorb the deviation of the busbar 25. Fig. 5C shows a case that the busbar 25 has deviated greatly forward (leftward in Fig. 5C) with respect to the main strip 21. In this case, the S shape of the bent portion 231 of the second branch portion 23 is stretched to absorb the deviation of the busbar 25. Although not shown in any drawings, when the main strip 21 is moved upward or downward and its relative positional relationships with the busbars 25 are thereby changed, the S shape of each bent portion 231 is stretched in the top-bottom direction to absorb that changes in the relative positional relationships.

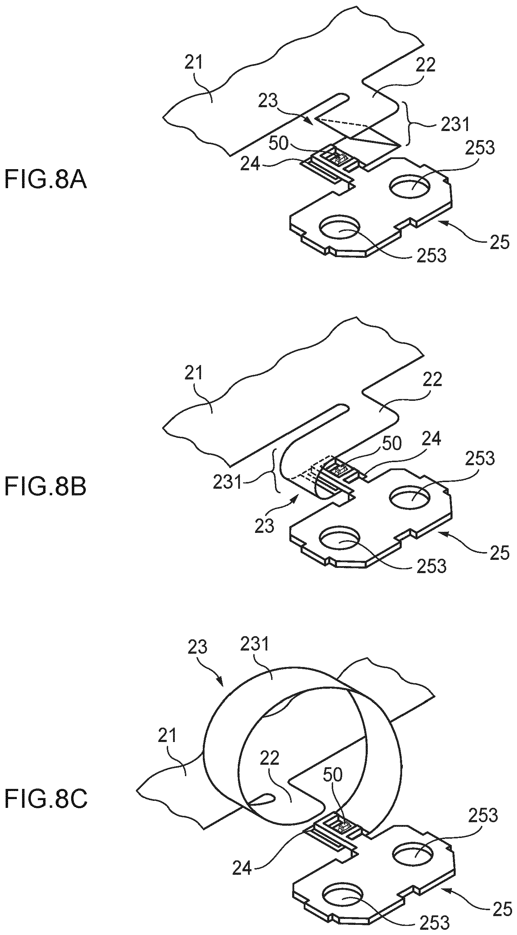

In the above-described embodiment, the bent portion 231 of each second branch portion 23 is bent so as to assume an S shape (or inverted S shape) as a whole. Alternatively, as shown in Fig. 8A, each bent portion 231 may assume a Z shape (or an inverted Z shape) as a whole. As another alternative, as shown in Fig. 8B, each bent portion 231 may be bent so as to assume assume a C shape (or an inverted C shape) as a whole. As a further alternative, as shown in Fig. 8C, each bent portion 231 may be formed so as to assume an O shape as a whole. As in the example shown in Fig. 8C, if necessary, the branch portions 22 and 23 may be formed so that the bottom surfaces of the main strip 21 and each connection portion 24 are in the same plane.

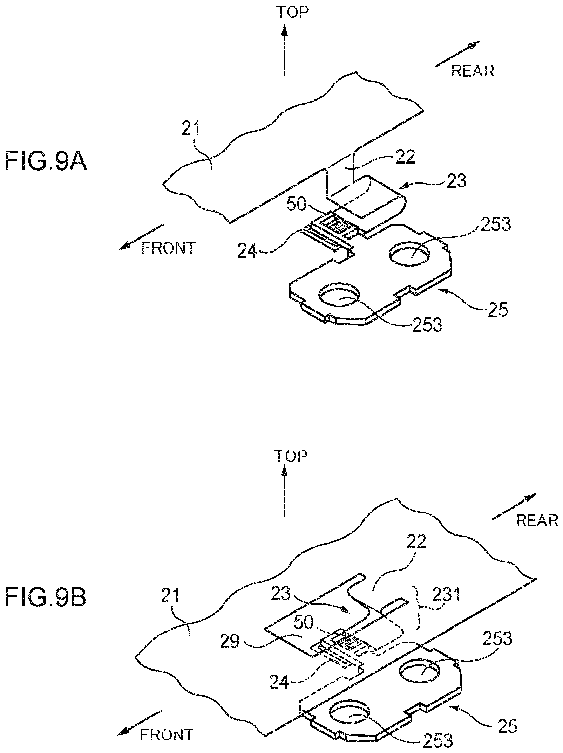

Although in the above embodiment each first branch portion 22 is in the same plane as the main strip 21, as shown in Fig. 9A each first branch portion 22 may extend in such a direction as to cross the bottom surface of the main strip 21 (e.g., in Fig. 9A the first branch portion 22 extends perpendicularly to the main strip 21, more specifically, downward). Although in the above-described embodiment each first branch portion 22 branches off the main strip 21 from its side edge, another alternative is possible in which as shown in Fig. 9B openings 29 are formed inside the main strip 21 and each first branch portion 22 branches off the main strip 21 from an edge of the associated opening 29.

### (Internal structures of main strip 21 and branch strips)

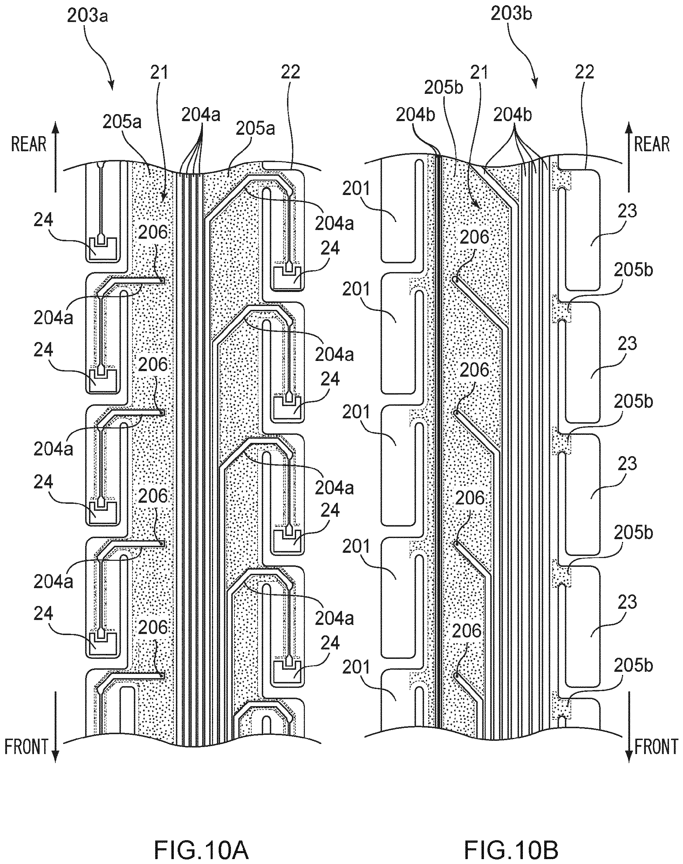

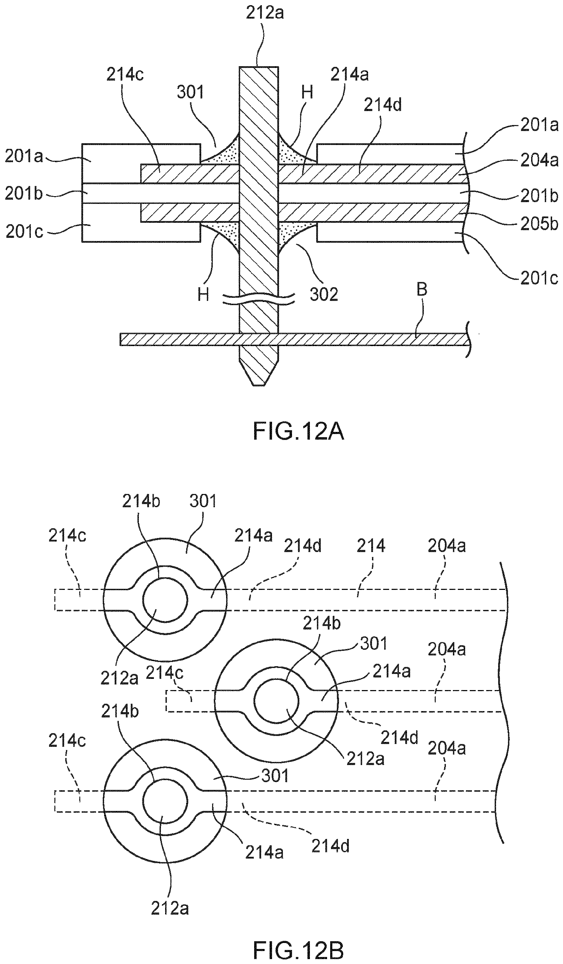

Next, the internal structures of the main strip 21, the first branch portions 22, and the second branch portions 23 which constitute the circuit body 20 will be described with reference to Figs. 10A and 10B to Figs. 12A and 12B.

As described above, the main strip 21, the first branch portions 22, and the second branch portions 23 which constitute the circuit body 20 are an FPC. As shown in Fig. 12A, the circuit body 20 (FPC) consists of resin layers 201a, 201b, and 201c (hereinafter referred to generically as a "resin layer 201") and a top metal layer 203a and a bottom metal layer 203b which are sandwiched by the resin layers 201a, 201b, and 201c of the resin layer 201. Typically, the resin layer 201 is made of polyimide and the top metal layer 203a and the bottom metal layer 203b are made of copper (Cu). In actuality, the circuit body 20 is provided with adhesive layers (not shown) for fixing the above layers to each other closely. However, the adhesive layers are not shown in Fig. 12A for the sake of convenience of description.

The top metal layer 203a which is located above (located on the front side of) the center plane, in the thickness direction, of the resin layer 201 and the bottom metal layer 203b which is located below (located on the back side of) the center plane, in the thickness direction, of the resin layer 201 are buried in the resin layer 201. The top metal layer 203a and the bottom metal layer 203b are spaced from each other in the thickness direction of the resin layer 201 and the resin layer 201b of the resin layer 201 is interposed between them. That is, the top metal layer 203a and the bottom metal layer 203b are insulated from each other.

The top metal layer 203a consists of top wiring patterns 204a which are part of the above-mentioned plural wiring patterns, top dummy patterns 205a which are independent of the top wiring patterns 204a, and the above-mentioned connection portions 24 which are independent of the top wiring patterns 204a.

The bottom metal layer 203b consists of bottom wiring patterns 204b which are the remaining part of the above-mentioned plural wiring patterns and bottom dummy patterns 205b which are independent of the bottom wiring patterns 204b. Corresponding ones of the top wiring patterns 204a and the bottom wiring patterns 204b are electrically connected to each other in the thickness direction of the circuit body 20 through a corresponding via hole 206.

Among the first branch portions 22 and the second branch portions 23 provided on the two sides in the width direction of the main strip 21, each set of a first branch portion 22 and a second branch portion 23 located on one side in the width direction (right side in each of Figs. 10A and 10B) is connected to the connector 212 which is connected to the front end portion of the circuit body 20 because the corresponding top wiring pattern 204a extends continuously from a position in the vicinity of a terminal portion of the second branch portion 23 to the connector 212 via the second branch portion 23, the first branch portion 22, and the main strip 21.

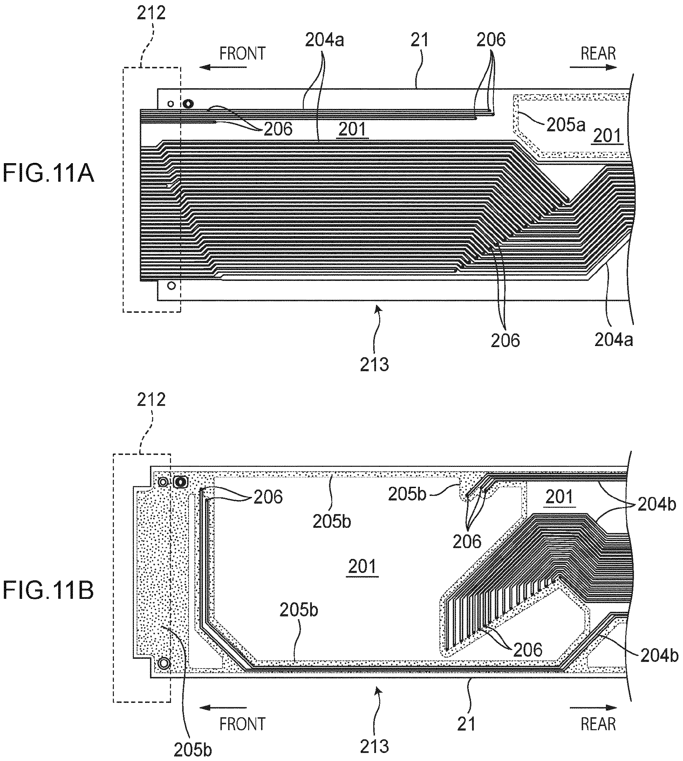

On the other hand, among the first branch portions 22 and the second branch portions 23, first, as shown in Fig. 10A, as for each set of a first branch portion 22 and a second branch portion 23 located on the other side in the width direction (left side in each of Figs. 10A and 10B), the corresponding top wiring pattern 204a extends from a position in the vicinity of a terminal portion of the second branch portion 23 to a via hole 206 that is located in the vicinity of the first branch portion 22 in the main strip 21 via the second branch portion 23 and the first branch portion 22. Then, as shown in Fig. 10B, the corresponding bottom wiring pattern 204b extends from the above via hole 206 to a via hole 206 (see Fig. 11B) located in the vicinity of the connector 212 in the main strip 21. Furthermore, as shown in Fig. 11A, the corresponding top wiring pattern 204a extends from the via hole 206 to the connector 212. In this manner, the first branch portion 22 and the second branch portion 23 are electrically connected to the connector 212. That is, in the front end portion, connected to the connector 212, of the main strip 21, the top wiring patterns 204a corresponding to all of the sets of a first branch portion 22 and a second branch portion 23 are connected to the connector 212 (see Fig. 11A) and no bottom wiring patterns 204b are connected to the connector 212 (see Fig. 11B).

Since the top wiring patterns 204a and the bottom wiring patterns 204b are collected before being connected to the connector 212 using both of the top metal layer 203a and the bottom metal layer 203b, the plural interconnections extending from the plural busbars 25 can be connected to the connector 212 after their arrangement order is changed to an order that corresponds to the arrangement order of the cells 2 (see Fig. 2). That is, the wiring patterns can be given what is called a potential order arrangement.

The top dummy patterns 205a and the bottom dummy patterns 205b are formed in most of the area of the portion, housed in the holder 30, of the main strip 21 (i.e., the portion excluding the exposed portion 213) excluding the areas occupied by the top wiring patterns 204a and the bottom wiring patterns 204b. The top dummy patterns 205a and the top wiring patterns 204a and the bottom dummy patterns 205b and the bottom wiring patterns 204b are spaced from each other so as not to be electrically connected to each other. The top dummy patterns 205a and the bottom dummy patterns 205b are provided mainly for the purpose of making the stiffness of the portion, housed in the holder 30, of the main strip 21 (i.e., the portion excluding the exposed portion 213) higher than that of the first branch portions 22 and the second branch portions 23.

As shown in Figs. 12A and 12B, terminals 212a corresponding to the connector 212 are provided in the front end portion of the circuit body 20 so as to penetrate through the circuit body 20 in its thickness direction. More specifically, conduction portions 214a that are portions of the top wiring patterns 204a are exposed to the outside through respective openings 301 formed in the top resin layer 201a. Through-holes 214b are formed through the respective conduction portions 214a and the terminals 212a are inserted in the respective through-holes 214b. The terminals 212a are electrically connected to the respective conduction portions 214a with solder H. The terminals 212a are electrically connected to a connection target component(s) (e.g., board B or busbars) in the connector 212.

Two portions of each conduction portion 214a, that is, a portion 214c that is closer to the end of the circuit body 20 than the opening 301 is and a portion 214d that is closer to the main strip 21 than the opening 301 is, are sandwiched between the protective layers 201a and 201b so as to overlap with them.

Likewise, openings 302 are formed in the bottom resin layer 201c. The terminals 212a are fixed, with solder H, to portions, exposed in the respective openings 302, of a bottom dummy pattern 205b. This fixing is not for electrical connection but for more reliable holding of the terminals 212a.

In this example, each conduction portion 214a is formed in such a manner that the portion 214c closer to the end of the circuit body 20 and the portion 214d that is closer to the main strip 21 are approximately on a straight line. However, if necessary, the two portions 214c and 214d may be inclined with respect to each other.

### (Main advantages of embodiment)

As described above, in the circuit body 20 according to the embodiment, the conduction portion 214a of each wiring pattern 204a is exposed through the corresponding opening 301 of the protective later 201a and has, around the opening 302, at least two overlap portions 214c and 214d which are located at such positions as to be sandwiched between the pair of protective layers 201a and 201b in the thickness direction of the flexible circuit board. With this structure, even if external force acts on a wiring pattern 204a (in particular, conduction portion 214a) via, for example, the terminal 212a connected to the conduction portion 214a, the overlap portions 214c and 214d sandwiched between the pair of protective layers 201a and 201b can receive the external force sustainably. As a result, peeling of each wiring pattern 204a from the protective layer 201a can be suppressed more successfully than in a case that there is only one overlap portion 214a or 214d (e.g., a conduction portion 214a is a portion including the end of each wiring pattern 204a that is only one wiring pattern extending from the conduction portion 214a).

Furthermore, each wiring pattern 204a whose peeling from the protective layer 201a is suppressed as described above is connected to the board B using the associated terminal 212a. As a result, in this connection structure, proper electrical connection between the board B and the circuit body 20 can be maintained even if unintended external force acts on the connection structure.

Still further, peeling of each wiring pattern 204a from the protective layer 201a in the portions 214c and 214d where the circuit body 20 is connected to the connector 212 can be suppressed. As a result, peeling or the like at the contact between each terminal 212a and the corresponding wiring pattern 204a due to, for example, curving of the circuit body 20 can be suppressed.

### Other Embodiments

The invention is not limited to the above embodiment and various modifications, improvements, etc. can be made as appropriate within the scope of the invention. The materials, shapes, sets of dimensions, numbers, locations, etc. of the respective constituent elements of the above embodiment are not limited to those disclosed but can be determined in desired manners as long as the invention can be implemented.

Features of the above-described busbar module 10 etc. according to the embodiment of the invention will be summarized below concisely in the form of items [1] to [3]:
[1] A circuit body (20) comprising a flexible circuit board including: a conductor wiring pattern (204a) for electrical connection; and a pair of protective layers (201a, 201b) sandwiching the wiring pattern (204a) to isolate the wiring pattern (204a) from outside,
   the wiring pattern (204a) having a conduction portion (214a) exposed to the outside through an opening (301) located on at least one of the pair of the protective layers (201a, 201b) and to be electrically connected to an external terminal,
   the conduction portion (214a) having at least two overlap portions (214c, 214d) located around the opening (301) and sandwiched between the pair of the protective layers (201a, 201b) in a thickness direction of the flexible circuit board.
[2] A connection structure of a board and a circuit body (20), the connection structure comprising: a board; the circuit body (20) according to the item [1]; and a terminal electrically connecting the board and the circuit body (20),
   the terminal passing through the opening (301) of the circuit body (20) and being soldered to the conduction portion (214a) exposed in the opening (301) to be connected to the wiring pattern (204a) and being electrically connected to a circuit wiring on the board.
[3] A busbar module to be attached to a battery assembly having a stack of a plurality of cells, the busbar module comprising:
   a circuit body (20) having a flexible circuit board: including a conductor wiring pattern (204a) for electrical connection; and a pair of protective layers (201a, 201b) sandwiching the wiring pattern (204a) to isolate the wiring pattern (204a) from outside;
   a connector connected to an end portion of the circuit body (20);
   a plurality of busbars (25) to be connected to corresponding electrodes of the plurality of the cells; and
   a holder (30) holdings the busbars (25) and being extendable in a stacking direction of the plurality of the cells,
   the wiring pattern (204a) having, at the end portion connected to the connector, a conduction portion (214a) exposed to the outside through an opening (301) located on at least one of the pair of the protective layers (201a, 201b) and to be electrically connected to an external terminal,
   the conduction portion (214a) having at least two overlap portions (214c, 214d) located around the opening (301) and sandwiched between the pair of the protective layers (201a, 201b) in a thickness direction of the flexible circuit board.

### REFERENCE SIGNS LIST

- 1:: Battery assembly
- 2:: Cell
- 3:: Battery main body (main body)
- 4:: Positive electrode
- 5:: Negative electrode
- 10:: Busbar module
- 20:: Circuit body
- 21:: Main strip
- 22:: First branch portion (branch strip)
- 23:: Second branch portion (branch strip)
- 231:: Bent portion
- 231A:: First bent portion
- 231B:: Second bent portion
- 24:: Connection portion
- 25:: Busbar
- 30:: Holder
- 201:: Resin layer
- 201a:: Protective layer
- 201b:: Protective layer
- 204a:: Wiring pattern
- 214a:: Conduction portion
- 214c, 214d:: Overlap portion
- 301:: Opening
- B:: Board
- L:: Axis

## Claims

1. A circuit body comprising a flexible circuit board including: a conductor wiring pattern for electrical connection; and a pair of protective layers sandwiching the wiring pattern to isolate the wiring pattern from outside,
the wiring pattern having a conduction portion exposed to the outside through an opening located on at least one of the pair of the protective layers and to be electrically connected to an external terminal,
the conduction portion having at least two overlap portions located around the opening and sandwiched between the pair of the protective layers in a thickness direction of the flexible circuit board.

2. A connection structure of a board and a circuit body, the connection structure comprising: a board; the circuit body according to Claim 1; and a terminal electrically connecting the board and the circuit body,
the terminal passing through the opening of the circuit body and being soldered to the conduction portion exposed in the opening to be connected to the wiring pattern and being electrically connected to a circuit wiring on the board.

3. A busbar module to be attached to a battery assembly having a stack of a plurality of cells, the busbar module comprising:
a circuit body having a flexible circuit board: including a conductor wiring pattern for electrical connection; and a pair of protective layers sandwiching the wiring pattern to isolate the wiring pattern from outside;
a connector connected to an end portion of the circuit body;
a plurality of busbars to be connected to corresponding electrodes of the plurality of the cells; and
a holder holdings the busbars and being extendable in a stacking direction of the plurality of the cells,
the wiring pattern having, at the end portion connected to the connector, a conduction portion exposed to the outside through an opening located on at least one of the pair of the protective layers and to be electrically connected to an external terminal,
the conduction portion having at least two overlap portions located around the opening and sandwiched between the pair of the protective layers in a thickness direction of the flexible circuit board.
